# EUROPÄISCHE PATENTSCHRIFT

(11) **EP 1 998 448 B1**
(45) Veröffentlichungstag und Bekanntmachung des Hinweises auf die Patenterteilung: **09.10.2013**
(21) Anmeldenummer: 08156716.6
(22) Anmeldetag: 22.05.2008
(51) Int. Cl.: H03K 3/037, H03K 19/007

(54) **Elektrischer Schaltkreis mit Doppel-Modul-Redundanz zur Handhabung von Single-Event-Effekten**
Electrical switching circuit with double-module redundancy for handling single-event effects
Circuit électrique doté d'une redondance à double module destinée à la manipulation d'effets d'événements uniques

(30) Priorität: 25.05.2007 DE 102007024983
(43) Veröffentlichungstag der Anmeldung: 03.12.2008
(73) Patentinhaber: IHP GmbH-Innovations for High Performance Microelectronics / Leibniz-Institut für innovative Mikroelektronik, 15236 Frankfurt / Oder (DE)
(72) Erfinder: Schoof, Gunter, 15236 Frankfurt (Oder) (DE)
(74) Vertreter: Eisenführ, Speiser & Partner

(56) Entgegenhaltungen:
- US-A- 6 104 211
- US-A1- 2002 074 609
- US-B1- 6 667 520

## Beschreibung

Die Erfindung betrifft einen elektrischen Schaltkreis mit einer sequentiellen Logikschaltung und mit einer der sequentiellen Logik nachgeschalteten ersten Auswahlschaltung, die ausgebildet ist, an ihrem Ausgang ein logisches Ausgangsignal auszugeben, das einer Mehrheit von drei Eingangssignalen entspricht, welche parallel an drei Eingängen der ersten Auswahlschaltung anliegen. Die Erfindung ist insbesondere für einen elektrischen Schaltkreis mit Doppel-Modul-Redundanz zur Handhabung von Single-Event-Effekten anwendbar.

Beim Betrieb integrierter Schaltungen treten bekanntlich sogenannte Single-Event-Effekte (SEE) auf, welche durch energiereiche Strahlung wie z. B. Protonen oder schwere Ionen ausgelöst werden. Eine derartige Strahlung kann in Anwendungsumgebungen unter anderem im Weltraum, in Kernreaktoren oder Teilchenbeschleunigern oft nicht vollständig abgeschirmt werden. Single-Event-Effekte weisen bezüglich der Häufigkeit ihres Auftretens im Vergleich mit der Taktfrequenz integrierter Schaltungen eine deutlich geringere Frequenz auf und werden daher zeitlich als einzelne und nicht etwa als gleichzeitig mehrfach auftretende Ereignisse betrachtet.

Bei den Single-Event-Effekten kann es insbesondere zum unerwünschten Umschalten eines gespeicherten Bitzustandes kommen, was als Single-Event-Upset (SEU) bekannt ist. Darüber hinaus sind Single-Event-Latchups (SEL) bekannt, welche sich in einem Kurzschluss der Betriebsspannung des Chips äußern. Der Latchup-Effekt besteht üblicherweise darin, dass eine parasitäre PNPN-Struktur, also eine Thyristorstruktur, eine leitende Verbindung schafft, welche die Spannungsversorgung über die elektronischen Bauteile kurzschließt. Die parasitäre Thyristorstruktur tritt als Teil eines PMOS- und NMOS-Transistorpaares auf. Infolge eines Latchup-Effekts werden die beteiligten Komponenten mit großer Wahrscheinlichkeit zerstört, wenn nicht rechtzeitig die Spannungsversorgung abgeschaltet wird. SEUs treten im Vergleich zu SELs wesentlich häufiger auf.

Um die vorgenannten Fehler bzw. auf den genannten Effekten basierenden Fehlfunktionen zu verhindern, werden bei herkömmlichen Schaltungen bestimmte redundante Schaltungsdesigns eingesetzt. Ein typischer Vertreter für den SEU-Schutz ist das Triple-Modular-Redundancy (TMR)-Design. Gegen die seltener auftretenden Ereignisse, wie die SELs, werden spezielle Maßnahmen im Layout, wie z. B. Schutzringe, eine spezielle Transistorform oder Ähnliches eingesetzt.

Andere bekannte Konzepte zur Vermeidung von SELs bestehen darin, externe Überwachungsschaltungen vorzusehen, welche die Stromaufnahme der zu schützenden integrierten Schaltung dauerhaft überwachen und die Schaltung beim Überschreiten vorgegebener maximaler Werte für die Stromaufnahme von der Spannungsversorgung trennen. Nachteilig an diesen bekannten Konzepten ist die lange Zeitdauer, die erforderlich ist, um den ursprünglichen Systemzustand wiederherzustellen.

Aus der zum Zeitpunkt der Einreichung der vorliegenden Patentanmeldung noch unveröffentlichten DE 10 2006 055 867.7 ist ein elektrischer Schaltkreis mit einer sequentiellen Logikschaltung und einer der sequentiellen Logikschaltung nachgeschalteten Auswahlschaltung bekannt. Die Auswahlschaltung, welche im Rahmen dieser Anmeldung auch als Voter-Schaltung bezeichnet wird, wird dort im Zusammenhang mit einem TMR-Design verwendet. Ihr sind die Ausgangssignale von drei parallelen Speicherelementen zugeführt, die nominell gleiche Eingangssignale empfangen. Am Ausgang der Voter-Schaltung liegt ein Ausgangssignal an, das einer Mehrheit der drei Eingangssignale entspricht.

Ein Nachteil des dort beschriebenen elektrischen Schaltkreises ist, dass das TMR-Design einen hohen Flächenbedarf in einer integrierten Schaltung hat.

Aus der Veröffentlichung US 2002/0074609 A1 ist Schaltkreis mit redundanten Schaltungsstrukturen bekannt. Dort ist beschrieben, dass zwei Flipflops ein identisches Eingangssignal empfangen und Ausgangssignale ausgeben, die einem sogenannten Mehrheitsschaltungskreis zugeführt sind. Dieser gibt ein Ausgangssignal aus, das der Mehrheit seiner drei Eingangssignale entspricht. Der Mehrheitsschaltungskreis hat drei Eingänge, wobei das Ausgangssignal des Mehrheitsschaltungskreises als ein Eingangssignal auf einen seiner drei Eingänge zurückgekoppelt sein kann und den übrigen zwei Eingängen die Ausgangssignale der beiden Flipflops zugeführt sind.

Die beiden Flipflops empfangen bei der aus dieser Veröffentlichung bekannten Schaltung dasselbe Eingangssignal. Daher kann den beiden Flipflops nur eine einzige logische Vorschaltung vorgeschaltet sein, die dieses Eingangssignal produziert. Die Verwendung nur einer einzigen Vorschaltung hat den Vorteil, dass dieser Schaltkreis insgesamt einen besonders geringen Flächenbedarf hat. Jedoch ist auf diese Weise nur ein begrenzter Schutz gegen Single-Event-Effekte erzielbar.

Aus der Veröffentlichung US 6,104,211 ist ebenfalls ein Schaltkreis mit redundanten Schaltungsstrukturen bekannt. Dort ist eine dreifache Redundanz implementiert, wobei Ausgangssignale dreier zueinander redundante Schaltungsabschnitte Fehlererkennungsschaltungen zugeführt sind, die überprüfen, ob ein ausgewähltes der drei Ausgangssignale den übrigen beiden Ausgangssignale entspricht. Ist dies nicht der Fall, so wird ein entsprechendes Signal über einem ersten Eingang eines UND-Glieds an eine sogenannte Auffangschaltung weitergeleitet. Der Ausgang dieser Auffangschaltung ist auf den zweiten Eingang des UND-Gliedes gekoppelt.

Das der vorliegenden Erfindung zugrunde liegende technische Problem ist es daher, einen elektrischen Schaltkreis mit einer sequentiellen Logikschaltung und einer der sequentiellen Logikschaltung nachgeschalteten Auswahlschaltung anzugeben, der in einem integrierten Schaltkreis weniger Fläche in Anspruch nimmt und der einen verbesserten Schutz gegen Single-Event-Effekte aufweist.

Das technische Problem wird durch einen elektrischen Schaltkreis gemäß Anspruch 1 gelöst. Der erfindungsgemäße elektrische Schaltkreis umfasst eine sequentielle Logikschaltung, die zwei Logiksignal-Eingänge hat, denen nominell identische logische Signale zugeführt sind, und die ausgebildet ist, die an den zwei Logiksignal-Eingängen eingehenden logischen Eingangssignale synchron in jeweils einem von zwei parallelen redundanten Schaltungszweigen der sequentiellen Logikschaltung zu verarbeiten und an einem jeweils zugeordneten ersten oder zweiten von zwei Logiksignal-Ausgängen der sequentiellen Logikschaltung auszugeben. Der elektrische Schaltkreis umfasst weiterhin eine der sequentiellen Logikschaltung nachgeschaltete erste Auswahlschaltung, die ausgebildet ist, an ihrem Ausgang ein logisches Ausgangsignal auszugeben, das einer Mehrheit von drei Eingangssignalen entspricht, welche parallel an drei Eingängen der ersten Auswahlschaltung anliegen, wobei ein erster der drei Eingänge mit dem ersten Logiksignal-Ausgang der sequentiellen Logikschaltung und ein zweiter der drei Eingänge mit dem zweiten Logiksignal-Ausgang der sequentiellen Logikschaltung verbunden ist, und wobei der Ausgang der ersten Auswahlschaltung auf einen dritten der drei Eingänge der Auswahlschaltung rückgeführt ist. Der erfindungsgemäße elektrische Schaltkreis umfasst ferner eine erste kombinatorische Logik und eine zur ersten redundante und parallelgeschaltete zweite kombinatorische Logik, die der ersten und zweiten sequentiellen Logikschaltung vorgeschaltet sind, wobei die erste kombinatorische Logik nur mit der ersten der zwei sequentiellen Logikschaltungen und die zweite kombinatorische Logik nur mit der zweiten der zwei sequentiellen Logikschaltungen verbunden ist, und eine der ersten Auswahlschaltung parallelgeschaltete und zu ihr redundante zweite Auswahlschaltung, die ausgebildet ist, an ihrem Ausgang ein viertes logisches Ausgangssignal auszugeben, das einer Mehrheit von drei Eingangssignalen entspricht, welche parallel an drei Eingängen der zweiten Auswahlschaltung anliegen, wobei einem ersten der drei Eingänge das erste logische Ausgangssignal der ersten sequentiellen Logikschaltung und einem zweiten der drei Eingänge das zweite logische Ausgangssignal der zweiten sequentiellen Logikschaltung zugeführt ist, und wobei das vierte logische Ausgangssignal der zweiten Auswahlschaltung auf einen dritten der drei Eingänge der zweiten Auswahlschaltung rückgeführt ist.

Dabei umfasst jede sequentielle Logikschaltung ein D-Flipflop, dem jeweils eines der nominell identischen logischen Eingangssignale zugeführt ist und das am Ausgang der sequentiellen Logikschaltung angeordnet und ausgebildet ist, das erste bzw. zweite logische Ausgangssignal auszugeben, wobei Taktsignaleingängen der D-Flipflops zueinander synchrone Taktsignale zugeführt sind. Ferner sind der ersten kombinatorischen Logik und dem Takteingang des ersten D-Flipflops ein erstes Taktsignal zugeführt und der zweiten kombinatorischen Logik und dem Takteingang des zweiten D-Flipflops ein vom ersten unabhängiges zweites Taktsignal zugeführt, das mit dem ersten Taktsignal synchron ist. Schließlich weisen die erste und zweite Auswahlschaltung jeweils eine Zusatzschaltung auf, an welcher eingangsseitig ein Ausgangssignal jeweils einer der zwei zueinander redundanten kombinatorischen Logikschaltungen anliegt und die ausgebildet ist, in einem bestimmten Zeitbereich vor und nach einer aktiven Taktflanke des jeweiligen Taktsignals dem dritten Eingang der betreffenden Auswahlschaltung anstelle des dritten Ausgangssignals der betreffenden Auswahlschaltung das an der jeweiligen Zusatzschaltung eingangsseitig anliegende Ausgangssignal der betreffenden kombinatorischen Logikschaltung zuzuführen.

Der elektrische Schaltkreis der vorliegenden Erfindung basiert auf einem an sich bekannten Doppel-Modul-Redundanz (DMR)-Design. Anstelle einer doppelten Redundanz am Ausgang der sequentiellen Logikschaltung bei dem TMR-Design hat der elektrische Schaltkreis der vorliegenden Erfindung also lediglich eine einfache Redundanz, also lediglich zwei statt drei zueinander redundante Module.

Dies reduziert den Flächenbedarf der sequentiellen Logikschaltungen gegenüber einem TMR-Design um einen redundanten Zweig. Dies wiederum reduziert den Flächenbedarf des elektrischen Schaltkreises insgesamt. Dieser Vorteil eines DMR-Designs setzt sich in weiter unten beschriebenen Ausführungsbeispielen fort, in denen das DMR-Design sich auch auf eine der jeweiligen sequentiellen Logikschaltung vorgeschaltete kombinatorische Logik erstreckt. Neben einem reduzierten Flächenbedarf hat der elektrische Schaltkreis der vorliegenden Erfindung im Ergebnis auch den Vorteil eines reduzierten Aufwands für das Schaltungsdesign.

Die Verwendung eines DMR-Designs mit wirksamem Schutz gegen Single-Event-Effekte gelingt jedoch erst mit den zusätzlichen, im Anspruch 1 genannten Maßnahmen. Der elektrische Schaltkreis der vorliegenden Erfindung beruht auf der Erkenntnis, dass ein einfacheres auf der Doppel-Modul-Redundanz beruhendes Design ermöglicht wird, wenn der Ausgang der Auswahlschaltung auf einen ihrer drei Eingänge zurückgeführt ist. Auf diese Weise wird eine neue Regel für die Signalauswahl realisiert: Wenn die zwei redundanten Logiksignale der sequentiellen Logikschaltung unterschiedlich sind, gibt das in zeitlicher Hinsicht letzte Ausgangssignal der Auswahlschaltung den Ausschlag für den aktuellen Auswahlzyklus der Auswahlschaltung. Mit Hilfe dieser Auswahlregel lässt sich, wie unten in Ausführungsbeispielen des elektrischen Schaltkreises der Erfindung näher beschrieben, ein wirksamer Schutz gegen Single-Event-Upsets erzielen, der einem mit Hilfe eines TMR-Designs erzielten Schutz in seiner Wirksamkeit nicht nachsteht.

Der Begriff nominell-identisch wird für Signale verwendet, um auszudrücken, dass die Signale aufgrund der Struktur der Schaltung im Normalbetrieb logisch identisch sind, jedoch im Ausnahmefall aufgrund von Single-Event-Effekten von einander abweichen können. Zu beachten ist, dass die so charakterisierten Signale aber auch bei Auftreten eines Single-Event-Effekts nicht voneinander abweichen müssen. So wird eine einfache, also nicht redundant vorgesehene kombinatorische Logikschaltung im Fall einer in ihr auftretenden Single-Event-Transiente möglicherweise ein fehlerhaftes logisches Ausgangssignal erzeugen, das ohne Single-Event-Transiente nicht erzeugt worden wäre. Wird dieses fehlerhafte Signal zwei redundanten sequentiellen Logikschaltungen zugeführt, so handelt es sich hierbei offensichtlich um zwar fehlerhafte, jedoch identische Signale.

Es ist daher zu beachten, dass die Verwendung der Wendung "nominell-identisch" nicht als inhärente Anforderung an die beanspruchte Schaltungsstruktur missverstanden werden darf. Die Wendung ist vielmehr als "zumindest nominell identisch" zu interpretieren. Mit anderen Worten als "entweder identisch oder bis auf mögliche Abweichungen aufgrund von Single-Event-Effekten identisch".

Der Nutzen der erfindungsgemäßen Schaltung beschränkt sich nicht auf die Handhabung der beschriebenen Single-Event-Effekte. Diesen äquivalent sind jegliche Effekte, die zu einer ausnahmsweise auftretenden Abweichung der Ausgangssignale zueinander redundanter sequentieller Logikschaltungen führen können.

Es sei noch erwähnt, dass im Rahmen der vorliegenden Anmeldung die Begriffe "Logik" und "Logikschaltung" gleichbedeutend verwendet werden. Der erfindungsgemäße elektrische Schaltkreis ist insbesondere ein integrierter Schaltkreis auf einem Chip, jedoch nicht hierauf beschränkt. Der elektrische Schaltkreis kann beispielsweise auch in Form eines System-in-Package (SIP) oder als Bestandteil eines SIP oder anderer Formen von Mehrfach-Chipanordnungen realisiert sein.

Jede sequentielle Logikschaltung umfasst ein Speicherelement, dem jeweils eines der nominell identischen logischen Eingangssignale zugeführt ist. Die Speicherelemente weisen jeweils einen Signaleingang auf.

Die sequentielle Logikschaltung ist nicht dahingehend beschränkt, dass sie lediglich ein Speicherelement enthalten muss, obwohl das derzeit als die einfachste und effizienteste Lösung erscheint. Eine sequentielle Logikschaltung, die aus nur einem Speicherelement besteht, hat den Vorteil, dass ihre Signalverarbeitung sowie die SEU-Fehlerkorrektur nur einen Taktzyklus in Anspruch nimmt. Es ist jedoch grundsätzlich auch möglich, in der jeweiligen sequentiellen Logikschaltung mehrere interne Speicherelemente vorzusehen. Die Signalverarbeitung einschließlich Fehlerkorrektur in der sequentiellen Logikschaltung nimmt dann mehrere Taktzyklen in Anspruch. Deshalb sollten interne Speicherelement-Ausgänge innerhalb der sequentiellen Logikschaltung zur Minimierung von Fehlern aufgrund von Single-Event-Upsets nicht direkt mit nachgeschalteten internen Speicherelement-Eingängen verbunden sein. Würde man mehrere interne Speicherelemente ohne SEU-Schutz in Serie direkt hintereinander schalten, so erhöhte sich das Risiko eines sich über mehrere Taktzyklen hinziehenden Fehlers in der von einem SEU betroffenen sequentiellen Logikschaltung.

Eine Risikominimierung wird in einer jeweiligen sequentiellen Logikschaltung mit mehreren internen Speicherelementen erreicht, wenn ein SEU-Schutz pro internem Speicherelement vorgesehen ist. In einer sequentiellen Logikschaltung, die in einer Serienschaltung mehrere interne Speicherelemente enthält, sind diese bevorzugt ebenfalls jeweils in Doppel-Redundanz vorgesehen, und sind je zwei solche zueinander redundante und parallele interne Speicherelemente ausgangsseitig mit einer internen Auswahlschaltung verbunden, welche die beschriebene erfindungsgemäße Auswahlregel implementiert. Der Ausgang der Auswahlschaltung kann dann einem in Signalflussrichtung nachfolgenden redundanten internen Speicherelementpaar der sequentiellen Logikschaltung zugeführt sein. Die sequentielle Logikschaltung hat in diesem Fall also vorzugsweise eine interne Struktur, die die beschriebene übergeordnete Grundstruktur wiederholt, zu welcher die sequentielle Logikschaltung gehört.

Der Ausgang des jeweiligen Speicherelements bildet zugleich den Ausgang der jeweiligen sequentiellen Logikschaltung. Das jeweilige Speicherelement ist also am Ausgang der betreffenden sequentiellen Logikschaltung angeordnet und ausgebildet, das erste bzw. zweite logische Ausgangssignal auszugeben.

Als Speicherelemente finden vorzugsweise Flipflops oder Latches Verwendung. Als geeignet haben sich beispielsweise D-Flipflops erwiesen. Den zwei D-Flipflops sind hierbei vorzugsweise an ihren Taktsignaleingängen zueinander synchrone Taktsignale zugeführt. Den Taktsignaleingängen der D-Flipflops können in alternativen Varianten wahlweise ein und dasselbe Taktsignal oder aber zwei voneinander unabhängige, jedoch miteinander synchrone Taktsignale zugeführt sein.

Die Verwendung zweier redundanter kombinatorischer Logiken ermöglicht, dass der elektrische Schaltkreis seine bestimmungsgemäße Funktion unabhängig vom Vorliegen eines Single-Event-Effekts fortführen kann. Andere Schaltungen, die mit dem elektrischen Schaltkreis verbunden sind, werden nicht durch eine etwaige Fehlfunktion aufgrund des Single-Event-Effekts im erfindungsgemäßen elektrischen Schaltkreis beeinträchtigt. Die Auswahlschaltung sorgt dafür, dass ein nicht beeinträchtigtes Signal verwendet wird. Diese Verwendung einer Doppel-Modul-Redundanz sowohl in der sequentiellen Logikschaltung als auch in der kombinatorischen Logik wird im Rahmen dieser Anmeldung auch als vollständige Redundanz bezeichnet. Die Verwendung zweier redundanter kombinatorischer Logikschaltungen erfordert die Verwendung zweier redundanter Auswahlschaltungen.

Die Auswahlschaltung selbst bildet eine spezielle kombinatorische Logikschaltung. Sie könnte in einer alternativen, jedoch hier nicht verwendeten Darstellungsweise zusammen mit anderen nachfolgenden Kombinatorikschaltungen als ein kombinatorischer Block betrachtet werden. Aus dieser Überlegung heraus wird jedoch klar, dass bei Verwendung zweier paralleler und zueinander redundanter Auswahlschaltungen ein SEU-Schutz hierfür wiederum mit Hilfe der erfindungsgemäßen Schaltungsstruktur, also, kurz gefasst, mit zwei nachgeschalteten, parallelen und zueinander redundanten sequentiellen Logikschaltungen und einer Auswahlschaltung erzielt werden kann.

Single-Event-Transienten sind besonders schwierig zu handhaben, wenn sie während einer aktiven Taktflanke auftreten. Ein solches Ereignis tritt zwar vergleichsweise selten auf. In einem elektrischen Schaltkreis mit nur einer kombinatorischen Logik kann eine erwähnte, selten auftretende Single-Event-Transiente während einer aktiven Taktflanke die Ausgangssignale beider Speicherelemente der sequentiellen Logik verfälschen, wodurch im Ergebnis auch die Auswahlschaltung ein fehlerhaftes Signal ausgeben wird. Die Wahrscheinlichkeit dieses Effektes wird zusätzlich verringert, wenn zwei zueinander redundante kombinatorische Logiken und zwei Auswahlschaltungen vorgesehen sind, wie oben beschrieben. Jedoch kann auch hier eine Single-Event-Transiente während einer aktiven Taktflanke ein fehlerhaftes Ausgangssignal des elektrischen Schaltkreises erzeugen, wenn nämlich eine an sich korrekt erfolgte Änderung des Ausgangssignals der kombinatorischen von einer Single-Event-Transiente im Zeitbereich der aktiven Taktflanke überdeckt wird. In diesem Fall wird die korrekte Signaländerung des anderen Speicherelements, welches der Single-Event-Transiente nicht ausgesetzt ist, von der Auswahlschaltung unzutreffender Weise als fehlerhaft bewertet.

Zur Vermeidung auch solcher äußerst seltener Single-Event-Effekte ist vorgesehen, dass die erste und zweite Auswahlschaltung jeweils eine Zusatzschaltung aufweisen. An einer jeweiligen Zusatzschaltung liegt eingangsseitig ein Ausgangssignal jeweils einer der zwei zueinander redundanten kombinatorischen Logikschaltungen an. Es bietet sich an, hierfür die im jeweils gleichen Schaltungsabschnitt liegende kombinatorische Logikschaltung zu verwenden. Die Zusatzschaltungen sind ausgebildet, in einem bestimmten Zeitbereich vor und nach einer aktiven Taktflanke des jeweiligen Taktsignals dem dritten Eingang der betreffenden Auswahlschaltung anstelle des dritten Ausgangssignals der betreffenden Auswahlschaltung das an der jeweiligen Zusatzschaltung eingangsseitig anliegende Ausgangssignal der betreffenden kombinatorischen Logikschaltung zuzuführen.

Die Zusatzschaltung entfaltet ihre vorteilhafte Wirkung bei Vorliegen einer tatsächlichen Differenz der an sich nominell-identischen logischen Eingangssignale der D-Flipflops der sequentiellen Logikschaltungen im zeitlichen Bereich einer aktiven Taktftänke. Eine solche Differenz wird durch die Wirkung der Zusatzschaltung ignoriert. Ansonsten hat die Zusatzschaltung den Vorteil, dass sie keine am Ausgang der Auswahlschaltung erkennbare Auswirkung auf die Funktionsweise des elektrischen Schaltkreises ausübt. Nachfolgend werden Ausführungsbeispiele des erfindungsgemäßen Schaltkreises beschrieben. Die zusätzlichen Merkmale der beschriebenen Ausführungsbeispiele können zur Bildung zusätzlicher Ausführungsbeispiele miteinander kombiniert werden, wenn sie nicht als alternativ zueinander beschrieben sind.

Die Zusatzschaltung kann mit Hilfe eines Multiplexers realisiert werden. Die Zusatzschaltung hat in einem Ausführungsbeispiel folgende Struktur:

Sie weist einen Multiplexer zwischen dem Ausgang der ersten Auswahlschaltung und dem mit ihm verbundenen dritten Eingang der ersten Auswahlschaltung auf, dem an parallelen ersten und zweiten Multiplexer-Signaleingängen das Ausgangssignal der ersten Auswahlschaltung und das logische Eingangssignal der zugeordneten sequentiellen Logikschaltung zugeführt sind. Dabei ist dem Multiplexer zusätzlich ein periodisches Hilfstaktsignal zugeführt, das zum Taktsignal synchron ist und Hilfstakt-Signalimpulse aufweist, die in einem bestimmten Zeitbereich vor und nach einer aktiven Taktflanke des jeweiligen Taktsignals ein konstantes logischen Hilfstakt-Signalniveau haben. Der Multiplexer ist ausgebildet, bei Vorliegen des Hilfstakt-Signalimpulses dem dritten Eingang der Auswahlschaltung anstelle des Ausgangs der Auswahlschaltung das eingangsseitig anliegende logische Signal zuzuführen.

Bei diesem Ausführungsbeispiel wird also das rückgeführte Ausgangssignal der Auswahlschaltung über einen Multiplexer geleitet. Der Multiplexer wird von einem Hilfstaktsignal gesteuert, das zum jeweiligen Taktsignal synchron ist und Hilfstakt-Signalimpulse aufweist, die in einem bestimmten Zeitbereich vor und nach einer aktiven Taktflanke des jeweiligen Taktsignals ein konstantes logisches Hilfstaktsignalniveau haben. Im Rhythmus dieser Hilfstakt-Steuerung leitet der jeweilige Multiplexer bei Vorliegen des Hilfstakt-Signalimpulses anstelle des Ausgangssignals der Auswahlschaltung das Ausgangssignal der ersten bzw. zweiten kombinatorischen Logik zu.

Vorzugsweise weisen hierbei das erste und zweite Speicherelement jeweils eine spezifizierte Haltezeit auf, die mindestens bis zum Ende eines jeweiligen Hilfstakt-Signalimpulses dauert. Das von der Kombinatorik erzeugte Eingangssignal muss entsprechend lange an den Speicherelementen anliegen.

Bei diesem Ausführungsbeispiel funktioniert die erläuterte Auswahlregel unabhängig von den Eingangssignalen an den beiden Speicherelementen wie gehabt, wenn ein Speicherelement aufgrund eines SEU im Zeitbereich außerhalb des Zeitbereichs der aktiven Taktflanke in den falschen Zustand kippt. Die Funktionsweise ist jedoch im Zeitbereich der aktiven Taktflanke dahingehend modifiziert, dass in diesem Zeitbereich das Ausgangssignal der kombinatorischen Logik den Ausschlag gibt, und nicht das zuletzt ausgegebene Signal der Auswahlschaltung. Kommt also eine Signalabweichung an den redundanten Speicherelementen während einer aktiven Taktflanke zum Tragen, wird nicht das Signal der Auswahlschaltung, sondern das am jeweiligen Signaleingang der Speicherelemente anliegende Signal über den Multiplexer an die Auswahlschaltung weitergeleitet.

Der Hilfstaktimpuls hat vorzugsweise eine Mindestlänge, die der maximalen Länge eines SET-Impulses entspricht. Damit wird sichergestellt, dass vor dem Umschalten des Multiplexers immer das richtige Signal am Voter anliegt. Tritt der SET-Impuls etwas später auf, sodass nicht das richtige Signal vom Multiplexer kommt, hat stattdessen das Flipflop einen korrekten Ausgangswert, da ja dann der SET nach der Taktflanke aufgetreten ist.

Mit dem zusätzlichen Logikaufwand der Zusatzschaltung und dem Bereitstellen des Hilfstaktsignals kann also ein wirksamer Effekt vor Single-Event-Upsets auch bei Auftreten während einer aktiven Taktflanke gewährleistet werden. Dieser Schutz ist spezifisch für ein DMR-Design und wird bei einem TMR-Design nicht benötigt.

Der Hilfstakt zur Steuerung der Zusatzschaltung wird in einem Ausführungsbeispiel mit Hilfe einer Hilfstaktschaltung erzeugt, die eingangsseitig das Taktsignal empfängt und die ausgebildet ist, das periodische Hilfstaktsignal auszugeben. Die Hilfstaktschaltung ist in einem Ausführungsbeispiel der Zusatzschaltung zugeordnet, bildet insbesondere einen Teil der Zusatzschaltung. Der Hilfstakt kann in einer alternativen Ausführungsform der Zusatzschaltung von extern zugeführt werden.

Die Auswahlschaltung kann zusammen mit der Zusatzschaltung und der zugeordneten Hilfstaktschaltung als Makrozelle vorgesehen werden, was den Schaltungsentwurf erleichtert.

Für einen zusätzlichen Schutz vor Single-Event-Latchups hat der elektrische Schaltkreis in einem Ausführungsbeispiel folgende Struktur: Eine erste kombinatorische Logik bildet mit einer nachgeschalteten ersten sequentiellen Logikschaltung und der dieser wiederum nachgeschalteten ersten Auswahlschaltung einen ersten Schaltkreisabschnitt. Die zweite kombinatorische Logik bildet mit der zweiten sequentiellen Logikschaltung und der zweiten Auswahlschaltung einen zweiten Schaltkreisabschnitt. Weiterhin weist der erste Schaltkreisabschnitt einen ersten Spannungsversorgungsanschluss und der zweite Schaltkreisabschnitt einen zweiten Spannungsversorgungsanschluss auf. Die Spannungsversorgungsanschlüsse sind mit unabhängigen Spannungsversorgungsquellen verbindbar. Dieser Ansatz erlaubt die Kombination eines Schutzes vor Single-Event-Upsets und vor Single-Event-Latchups auf der Ebene des Schaltungsentwurfs und nutzt dabei die Vorteile der Redundanz, die für SEU-Schutz erforderlich ist, auch für einen SEL-Schutz. Insbesondere wird eine Handhabung beider Single-Event-Effekte in Echtzeit ermöglicht.

Die beschriebene Struktur ermöglicht in einem bevorzugten Ausführungsbeispiel das Vorsehen einer ersten Steuereinheit im ersten Schaltkreisabschnitt, wobei die erste Steuereinheit mit dem zweiten Schaltkreisabschnitt verbunden und ausgebildet ist, in Reaktion auf ein Auftreten eines Single-Event-Latchups im zweiten Schaltkreisabschnitt die Stromaufnahme des zweiten Schaltkreisabschnittes zu begrenzen. Weiterhin ist in diesem bevorzugten Ausführungsbeispiel der zweite Schaltkreisabschnitt mit einer zweiten Steuereinheit versehen, die mit dem ersten Schaltkreisabschnitt verbunden ist und die ausgebildet ist, in Reaktion auf ein Auftreten eines Single-Event-Latchups im ersten Schaltkreisabschnitt die Stromaufnahme des ersten Schaltkreisabschnitts zu begrenzen. Die erste bzw. zweite Steuereinheit umfasst jeweils einen Latchup-Detektor, der ausgebildet ist, einen auf einem Single-Event-Latchup beruhenden Stromausschlag zu detektieren.

Ausführungsbeispiele der Erfindung sind auch in den abhängigen Patentansprüchen angegeben.

Nachfolgend werden weitere Ausführungsbeispiele der Erfindung unter Bezugnahme auf die beigefügten Figuren erläutert. Es zeigen:
Fig.1a eine vereinfachte Darstellung eines ersten Ausführungsbeispiels eines elektrischen Schaltkreises;
Fig. 1b und c Beispiele geeigneter Auswahlschaltungen zur Verwendung im elektrischen Schaltkreis der Fig. 1a;
Fig. 2 eine vereinfachte Darstellung eines zweiten Ausführungsbeispiels eines elektrischen Schaltkreises, der einen vollständig redundanten Aufbau aufweist;
Fig. 3 eine vereinfachte Darstellung einer Hälfte eines dritten Ausführungsbeispiels eines elektrischen Schaltkreises, bei dem die Auswahlschaltung eine Zusatzschaltung zur Handhabung von Single-Event-Upsets im Zeitbereich einer aktiven Taktflanke aufweist
Fig. 4 eine Variante des in Fig. 3 gezeigten elektrischen Schaltkreises;
Fig. 5 eine Darstellung des Zeitverlaufs verschiedener Signale in den Schaltungen der Figuren 3 und 4;
Fig. 6 ein Ausführungsbeispiel eines elektrischen Schaltkreises auf der Basis des Ausführungsbeispiels der Fig. 4, bei dem wesentliche Elemente in Form einer Makrozelle zusammengefasst sind;
Fig. 7 eine vereinfachte Darstellung eines weiteren Ausführungsbeispiels eines elektrischen Schaltkreises;
Fig. 8 eine vereinfachte Darstellung eines Ausführungsbeispiels eines elektrischen Schaltkreises mit Steuereinheiten zur zusätzlichen Handhabung von Single-Event-Latchups;
Fig. 9 eine Variante des Schaltkreises der Fig. 8 in Form einer Speicherschaltung mit Schutz gegen Single-Event-Upsets und Single-Event-Latchups; und
Fig. 10 eine schematische Darstellung eines anwendungsspezifischen integrierten Schaltkreises mit Schutz gegen Single-Event-Upsets und Single-Event-Latchups.

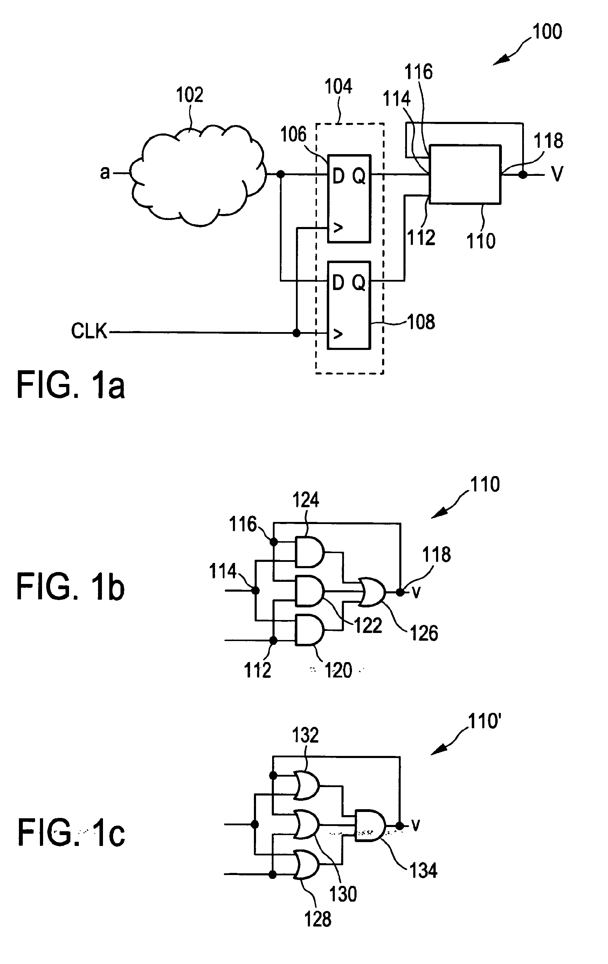

Fig. 1a zeigt eine vereinfachte Darstellung eines ersten Ausführungsbeispiels eines Ausschnitts eines elektrischen Schaltkreises 100. Der elektrische Schaltkreis 100 ist in Fig. 1a stark vereinfacht dargestellt. Nur für die Beschreibung der vorliegenden Erfindung wesentliche Schaltungselemente sind dargestellt.

Der mit dem elektrischen Schaltkreis erzielte SEU -Schutz erstreckt sich auf alle diese Ausschnitte in ihrer Gesamtheit. Z.B. kann die Kombinatorik an bestimmten Stellen des Schaltkreises auch entfallen (Zähler-/Teilerschaltungen).

Der elektrische Schaltkreis 100 enthält eine kombinatorische Logik 102, die der Funktion des elektrischen Schaltkreises entsprechend erforderliche logische Funktionen implementiert. In der Schaltungstechnik werden als kombinatorische Logik bekanntlich Netzwerke von Logikgattern bezeichnet, deren Ausgangssignal unabhängig von der Vorgeschichte während des Betriebs der Schaltung ausschließlich durch das Eingangssignal bestimmt ist. Kombinatorische Logikschaltungen können mit Hilfe von Wahrheitstabellen und logischen Funktionen beschrieben werden. Beispiele für kombinatorische Logikschaltungen sind Komparatoren, Dekoder, Code-Umsetzer, Addierer/Subtrahierer etc. Die kombinatorische Logik 102 hat einen Signaleingang a. Es versteht sich, dass der kombinatorischen natorischen Logik in anderen Ausführungsbeispielen auch mehrere Eingangssignale an unterschiedlichen Signaleingängen zugeführt sein können.

Der kombinatorischen Logik 102 ist ein sequentielle Schaltungsblock 104 nachgeschaltet. Der sequentielle Schaltungsblock 104 umfasst im vorliegenden Ausführungsbeispiel zwei parallele und zueinander redundante sequentielle Logikschaltungen 106 und 108. Eine sequentielle Logikschaltung entsteht bekanntlich durch das Vorsehen von Speicherelementen.

Im vorliegenden Ausführungsbeispiel besteht jede der sequentiellen Logikschaltungen 106 und 108 aus einem D-Flipflop. Die mit D gekennzeichneten Logiksignaleingänge der D-Flipflops 106 und 108 sind parallel mit dem Ausgang der kombinatorischen Logik 102 verbunden. Den Speicherelementen 106 und 108 werden also identische logische Signale zugeführt.

Die D-Flipflops 106 und 108 weisen weiterhin Taktsignaleingänge auf, die mit dem Symbol ">" gekennzeichnet sind. Den Taktsignaleingängen der Flipflops 106 und 108 wird parallel dasselbe Taktsignal CLK zugeführt.

Die sequentielle Logikschaltung 104 hat zwei Logiksignalausgänge, die im vorliegenden Ausführungsbeispiel von den Q-Ausgängen der D-Flipflops 106 und 108 gebildet werden.

Der sequentiellen Logikschaltung 104 ist eine Auswahlschaltung 110 nachgeschaltet. Die Auswahlschaltung 110 hat drei Eingänge 112, 114 und 116 und einen Ausgang 118. Die Auswahlschaltung 110 ist ausgebildet, an ihrem Ausgang 118 ein logisches Ausgangssignal V auszugeben, das einer Mehrheit der an ihren drei Eingängen 112 bis 116 anliegenden Signale entspricht. Hierbei liegt an den Eingängen 112 und 114 der jeweilige Ausgang der D-Flipflops 108 und 106 an. Am dritten Eingang 116 liegt das Ausgangssignal V der Auswahlschaltung 118 selbst an.

Die Auswahlschaltung ist ausgebildet, an ihrem Ausgang 118 ein logisches Ausgangssignal auszugeben, das der Mehrheit der an den Eingängen 112 bis 116 anliegenden Eingangssignale entspricht. Beispiele von geeigneten Auswahlschaltungen sind in den Figuren 1b und 1c dargestellt. Die Auswahlschaltung 110 enthält in der Variante der Fig. 1b drei parallele UND-Gatter 120, 122 und 124. Das UND-Gatter 120 ist eingangsseitig mit dem D-Flipflop 108 und mit dem D-Flipflop 106 verbunden. Das UND-Gatter 122 ist eingangsseitig mit dem D-Flipflop 108 und dem rückgeführten Ausgang 118 der Auswahlschaltung 110 verbunden. Das UND-Gatter 124 schließlich ist eingangseitig mit dem D-Flipflop 106 und dem Ausgang 118 der Auswahlschaltung 110 verbunden. Die Ausgänge der UND-Gatter 120 bis 124 sind den drei Eingängen eines ODER-Gatters 126 zugeführt. Wie leicht nachvollziehbar ist, gewährleistet diese Auswahlschaltung, dass stets dasjenige Signal am Ausgang 118 ausgegeben wird, welches an der Mehrheit der Eingänge 112, 114 und 116 anliegt.

Eine Alternative zur Auswahlschaltung 110 ist in Fig. 1c dargestellt. Die Auswahlschaltung 110' der Fig. 1c enthält anstelle der UND-Gatter 120 bis 124 des Ausführungsbeispiels der Fig. 1b drei ODER-Gatter 128 bis 132, die zueinander parallel geschaltet sind, und denen ein UND-Gatter 134 nachgeschaltet ist. Die Verschaltung der ODER-Gatter 128 bis 132 entspricht der Verschaltung der UND-Gatter 120 bis 124 in der Auswahlschaltung 110.

Die sequentielle Logik 104 und die Auswahlschaltung 110 bewirken im Betrieb des elektrischen Schaltkreises 100, dass im Falle einer Differenz zwischen den redundanten Eingangssignalen der Auswahlschaltung 110 der bisher am Ausgang der Auswahlschaltung 110 anliegende logische Signalwert den Ausschlag für das nächste Ausgangssignal der Auswahlschaltung gibt. Im vorliegenden Fall kann eine Differenz zwischen den Eingangssignalen der Auswahlschaltung nur durch einen Fehler in der sequentiellen Logik 104 verursacht sein. Beispielsweise kann einer der D-Flipflops 106 und 108 von einem Single-Event-Upset (SEU) betroffen sein.

Der elektrische Schaltkreis 100 ist jedoch nicht in der Lage, ein durch eine Single-Event-Transiente in der kombinatorischen Logik 102 hervorgerufenes SEU zu kompensieren. Solch ein SEU kann allerdings nur auftreten, wenn er während einer aktiven Taktflanke am Flipflop-Eingang erscheint und das richtige Signal verfälscht. Ein solches Ereignis ist aufgrund der kurzen Zeitdauer der Taktflanke unwahrscheinlich, wenn auch nicht ausgeschlossen.

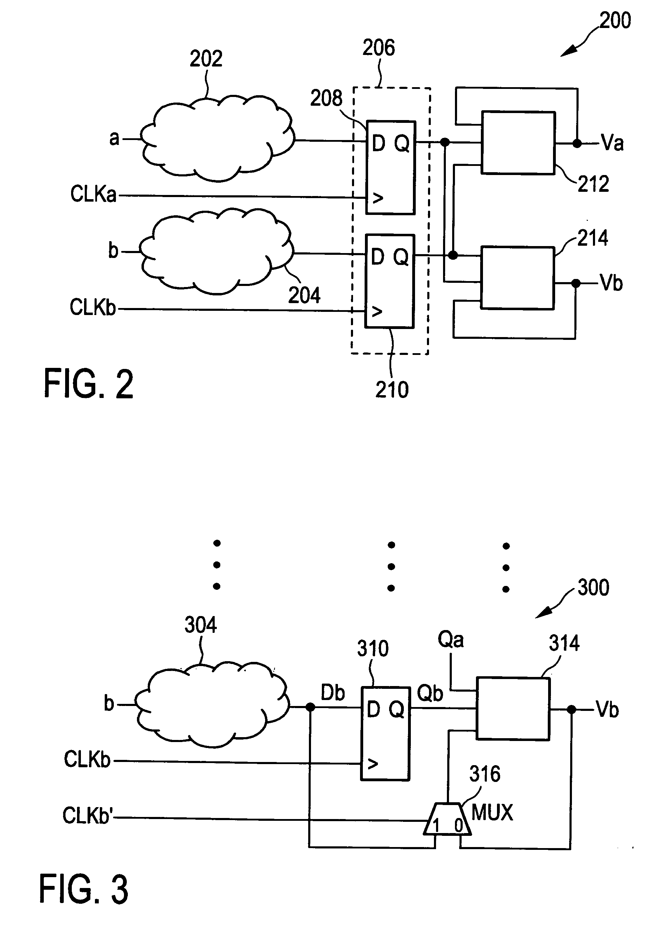

Eine in dieser Hinsicht verbesserte Struktur bildet der elektrische Schaltkreis der Fig. 2. Fig. 2 zeigt eine vereinfachte Darstellung eines zweiten Ausführungsbeispiels eines elektrischen Schaltkreises 200, der einen vollständig redundanten Aufbau aufweist.

Im elektrischen Schaltkreis 200 sind nicht nur zwei zueinander redundante sequentielle Logikschaltungen 208 und 210, sondern auch zwei redundante kombinatorische Logikschaltungen 202 und 204 vorgesehen. Die kombinatorischen Logikschaltungen 202 und 204 sind identisch aufgebaut, zumindest jedoch funktionell identisch. Das bedeutet, dass im Normalbetrieb bei gleichen logischen Eingangssignalen an den Eingängen a und b der kombinatorischen Logikschaltungen 202 und 204 auch identische Ausgangssignale am jeweiligen Ausgang der kombinatorischen Logikschaltung 202 bzw. 204 anliegen. Der sequentielle Logikschaltungsblock 206 umfasst wie im Ausführungsbeispiel der Fig. 1a zwei sequentielle Logikschaltungen in Form zweier D-Flipflops 208 und 210. Dem Signaleingang des D-Flipflops 208 ist das Ausgangssignal der kombinatorischen Logik 202 zugeführt und dem Signaleingang des D-Flipflops 210 das Ausgangssignal der kombinatorischen Logik 204. Anders als im Ausführungsbeispiel der Fig. 1a sind bei dem elektrischen Schaltkreis 200 der Fig. 2 die D-Flipflops von jeweils eigenen Taktgeneratoren mit Taktsignalen CLKa bzw. CLKb getaktet. Die Taktsignale sind synchron zueinander, weisen also einen möglichst kleinen oder vollständig verschwindenden Takt-Versatz (engl. clock skew) auf.

Weiterhin sind in dem elektrischen Schaltkreis 200 der Fig. 2 zwei redundante Auswahlschaltungen 212 und 214 vorgesehen. Die Verschaltung beider Auswahlschaltungen 212 und 214 entspricht der Verschaltung der Auswahlschaltung 110 in Fig. 1a. Auf diese Weise liegt in jedem der beiden redundanten Schaltungszweige die gleiche Information am Ausgang der jeweiligen Auswahlschaltung 212 bzw. 214 vor. Diese kann in nachgeschalteten, hier nicht dargestellten weiteren redundanten Schaltungsteilen jeweils unabhängig weiter verwendet werden.

Die Auswahlschaltungen der Fig. 1a und Fig. 2 sind in der Lage, eine Vielzahl von Single-Event-Upsets in der sequentiellen Logik sowie, im Ausführungsbeispiel der Fig. 2, in der kombinatorischen Logik zu handhaben.

Sie sind jedoch empfindlich gegenüber einer Single-Event-Transiente, die ein fehlerhaftes Signal während einer aktiven Taktflanke der Flipflops am Ausgang der sequentiellen Logikschaltung hervorruft. Im Fall des Ausführungsbeispiels der Fig. 1 betrifft diese Empfindlichkeit generell SETs während einer Taktflanke sowie SETs auf dem Taktsignal und anderen Steuersignalen, wie z.B. auf einem Set- oder Reset-Signal. Der elektrische Schaltkreis 200 der Fig. 2 ist dagegen nur gegen solche Ereignisse ungeschützt, bei denen ein SET während einer aktiven Taktflanke auftritt, der das richtige Schalten eines Flipflops verhindert. In diesem Fall würde eine ordnungsgemäß entstandene Signaländerung in dem nicht betroffenen Schaltungszweig bzw. dem nicht betroffenen D-Flipflop in unzutreffender Weise als Fehler bewertet.

Zur teilweisen Behebung dieses Problems könnte beim elektrischen Schaltkreis 200 eine Auswahlschaltung zwischen die kombinatorischen Logikschaltungen und die sequentielle Logik geschaltet werden. Auf diese Weise würde die Empfindlichkeit der kombinatorischen Logik gegenüber Single-Event-Transienten während einer aktiven Taktflanke beseitigt. Jedoch könnte eine Single-Event-Transiente in den Speicherelementen der zueinander redundanten sequentiellen Logikschaltungen oder in der Auswahlschaltung selbst während einer aktiven Taktflanke weiterhin einen Fehler hervorrufen.

Alternativ könnte man auch ein Verzögerungsglied einer Verzögerungsdauer, die einer maximalen SET-Dauer entspricht, vor einen der Flipflop-Eingänge schalten und damit verhindern, dass SETs an beiden Eingängen gleichzeitig auftreten können.

Eine mit Blick auf dieses Problem bevorzugte verbesserte Lösung stellt Fig. 3 vor. Fig. 3 zeigt eine vereinfachte Darstellung eines dritten Ausführungsbeispiels eines elektrischen Schaltkreises 300, bei dem die Auswahlschaltung eine Zusatzschaltung zur Handhabung von Single-Event-Upsets im Zeitbereich einer aktiven Taktflanke aufweist. Der Einfachheit halber ist vom elektrischen Schaltkreis 300 nur ein Schaltungszweig dargestellt. Ein vorhandener zweiter Schaltungszweig, der mit dem ersten Schaltungszweig in einer der Fig. 2 entsprechenden Weise verschaltet ist, ist hier nicht gezeigt. Der Einfachheit halber sind weiterhin in Fig. 3 für gegenüber Fig. 2 identische Strukturelemente Bezugszeichen verwendet, die sich von denen der Fig. 2 nur in ihrer ersten Ziffer unterscheiden. Hier ist für das Ausführungsbeispiel der Fig. 3 eine "3" verwendet, während es dort eine "2" ist.

Der elektrische Schaltkreis 300 der Fig. 3 enthält eine Zusatzschaltung in Form eines der Auswahlschaltung 314 zugeordneten Multiplexers 316. Der Multiplexer 316 ist einerseits direkt mit dem Ausgang der kombinatorischen Logik 304 und andererseits mit dem Ausgang der Auswahlschaltung 314 verbunden. Weiterhin wird der Multiplexer 316 von einem Hilfstakt CLKb' gesteuert. Das Hilfstaktsignal liefert Hilfstakt-Signalimpulse, die zum Taktsignal CLKb synchron sind und die im Unterschied zum Taktsignal CLKb in einem bestimmten Zeitbereich vor und nach einer aktiven Taktflanke des Taktsignals CLKb ein konstantes logisches Hilfstakt-Signalniveau haben.

Je nach Flipflop-Typ können unterschiedliche bzw. beide Taktflanken relevant sein. Die relevante Taktflanke wird im Rahmen dieser Anmeldung als ,,aktive Taktflanke" bezeichnet. Für eine aktive Taktflanke ist das Hilfstaktsignal im Beispiel ein positiver Impuls. Die zeitliche Dauer des Hilfstakt-Signalimpulses ist so zu wählen, dass sie größer ist als ein strahlungsindizierter Transientenimpuls. Eine geeignete Dauer des Hilfstakt-Signalimpulses hängt von zahlreichen, dem Fachmann an sich bekannten Faktoren ab und ist in Abhängigkeit von der zu erwartenden Strahlenbelastung sowie technologieabhängig zu ermitteln. In einem Beispiel erwies sich eine Dauer des Hilfstakt-Signalimpulses von etwa 200 ps als geeignet. Zu beachten ist, dass die Haltezeit des Flipflop-Eingangssignals so verlängert werden muss, dass es während der Dauer des Hilfstaktsignals noch anliegt.

Mit Hilfe des Multiplexers 316 gelingt eine Korrektur eines von einem strahlungsinduzierten Transientenimpuls in der kombinatorischen Logik oder in der sequentiellen Logik verursachten Fehlers. Verhindert dieser Transientenimpuls, dass sich der Flipflop-Ausgang auf einen neuen Wert ändert, so sorgt der Multiplexer 316 dafür, dass das korrekt geänderte Signal während der aktiven Taktflanke direkt vom Ausgang der kombinatorischen Logik an die Auswahlschaltung 314 geleitet wird. Während der Dauer des Hilfstakt-Signalimpulses ist die Auswahlregel also dahingehend geändert, dass nicht der bisherige Ausgang der Auswahlschaltung 314 den Ausschlag für die Signalauswahl gibt, sondern der Ausgang der kombinatorischen Logik 304. Mit dieser leicht abgewandelten Auswahlregel kann auch ein SEU während der aktiven Taktflanke kompensiert werden.

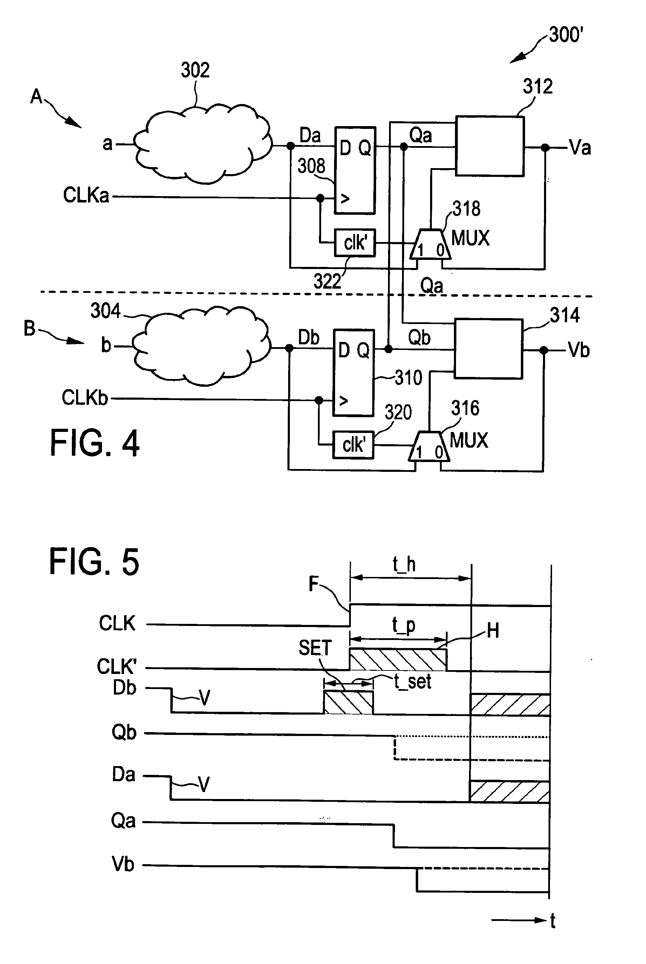

Fig. 4 zeigt eine Variante 300' der Auswahlschaltung 300, bei der die Hilfstakterzeugung unmittelbar vor dem Multiplexer mit Hilfe einer Hilfstaktschaltung 320 bzw. 322 vorgenommen wird. In Fig. 4 sind die zwei vollständig zueinander redundanten Schaltungsabschnitte A und B vollständig dargestellt. Zur Verdeutlichung ist eine gestrichelte Trennlinie zwischen den Schaltungsabschnitten A und B eingezeichnet.

Fig. 5 zeigt eine Darstellung des Zeitverlaufs verschiedener Signale in den Schaltungen der Figuren 3 und 4. Fig. 5 zeigt das Vorliegen eines Single-Event-Upsets in der kombinatorischen Logik 304 anhand eines Extra-Signalimpulses SET im Signalverlauf des Signals Db am Ausgang der kombinatorischen Logikschaltung 304. Im parallelen, redundanten Zweig der kombinatorischen Logikschaltung 302 tritt der Extra-Signalimpuls SET nicht auf, wie dem zeitlichen Verlauf des Signals Da in Fig. 5 entnehmbar ist.

Im Vergleich mit dem Taktsignal CLK zeigt sich, dass ein SET im Bereich der aktiven Taktflanke F des Taktsignals CLK auftritt. Dies würde im Ausführungsbeispiel der Fig. 2 zu einem SEU führen, sodass das Ausgangssignal Vb der Auswahlschaltung 214 in Fig. 2 in unzutreffender Weise ein hohes Signalniveau halten würde (vgl. gestrichelte graue Linie im Signalverlauf des Signals Vb), weil das an der vorherigen aktiven Taktflanke (nicht dargestellt) ausgegebene Signal ebenfalls ein hohes Signalniveau hatte. Der zwischenzeitlich erfolgte Wechsel vom hohen zum niedrigen Signalniveau am Ausgang der kombinatorischen Logikschaltung 304 (vgl. Bezugszeichen U in Fig. 5) würde somit von der Auswahlschaltung 214 der Fig. 2 nicht als wahres Signal interpretiert. Mit Hilfe des Hilfstaktsignals CLK' und des Multiplexers 316 gelingt bei dem elektrischen Schaltkreis 300 bzw. 300' der Figuren 3 und 4 eine korrekte Auswahl des zutreffenden Ausgangssignals. Denn das fehlerhaft hohe Signalniveau des Ausgangssignals Qb des Flipflops 306 wird während der aktiven Taktflanke von der Auswahlschaltung 314 nicht berücksichtigt. Stattdessen wird während der Dauer des Hilfstakt-Signalimpulses H das Ausgangssignal Db am Eingang der Auswahlschaltung 314 gewichtet.

In Fig. 5 ist erkennbar, dass die Haltezeit t_h des Flipflops 306 bzw. 308 größer ist als die Dauer des Hilfstaktsignalimpulses H. Die Dauer t_p des Hilfstaktimpulses H ist größer gewählt als eine maximal zu erwartende SET-Dauer (t_set).

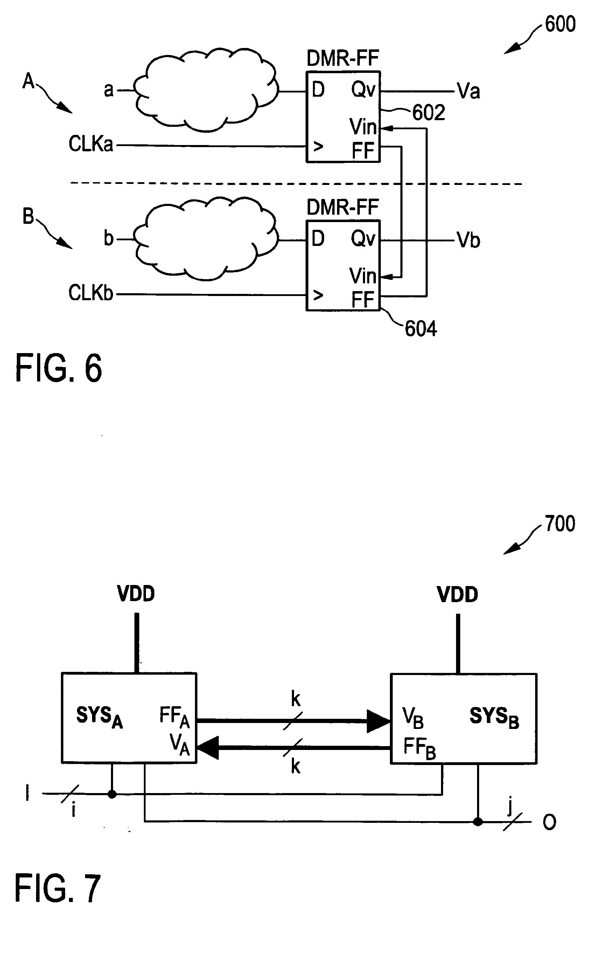

Fig. 6 zeigt ein in seiner Funktion der Fig. 4 entsprechendes Ausführungsbeispiel eines elektrischen Schaltkreises 600, bei dem im jeweiligen Schaltkreisabschnitt A bzw. B das Flipflop der sequentiellen Logik die Auswahlschaltung, die Hilfstaktschaltung und der Multiplexer 316 als jeweilige Makrozelle 602 bzw. 604 realisiert sind. Man kann die Makrozelle als 602 bzw. 604 als besondere Sorte Flipflop, nämlich als DMR-Flipflop DMR-FF bezeichnen. Mit Hilfe der Bildung solcher Makrozellen gelingt ein besonders ökonomischer Schaltungsentwurf. Ein Ausgang FF der Makrozelle 602 bzw. 604 entspricht dem Ausgang Q des betreffenden D-Flipflops 308 bzw. 310. Ein Eingang Vin der Makrozelle 602 bzw. 604 entspricht dem jeweiligen Eingang der Auswahlschaltung 312 bzw. 314, der mit dem Flipflop des jeweils anderen Schaltungsabschnittes verbunden ist. Am jeweiligen Ausgang Qv der Makrozelle 602 bzw. 604 wird das Ausgangssignal der jeweiligen Auswahlschaltung ausgegeben.

Fig. 7 zeigt eine vereinfachte Darstellung eines weiteren Ausführungsbeispiels eines elektrischen Schaltkreises 700. Im Beispiel der Fig. 7 sind die von der jeweiligen kombinatorischen Logikschaltung und dem jeweiligen Teil der sequentiellen Logikschaltung sowie der Auswahlschaltung gebildeten Schaltungsteile in zwei unabhängig mit elektrischer Leistung versorgten Schaltungsabschnitten SYSₐ und SYS_{B} realisiert. Ein Signalaustausch zwischen den Schaltungsabschnitten erfolgt entsprechend den in den Fig. 2 bis 4 gezeigten Verknüpfungen zwischen den Speicherelementen (bspw. Flipflops) eines Schaltungsabschnittes und der Auswahlschaltung des jeweils anderen Schaltungsabschnittes. Die Darstellung geht von einer Anzahl k von Speicherelementen pro Schaltungsabschnitt aus, eine entsprechende Anzahl von Auswahlschaltungen ist jeweils vorgesehen. Dabei umfasst der Begriff "Schaltungsabschnitt" komplexere Schaltungen als in den bisherigen Figuren dargestellt, die also mit mehr als zwei Speicherelementen und Auswahlschaltungen versehen sein können.

Das in Fig. 7 vorgeschlagene Schaltungsdesign mit zwei vollständig redundanten Schaltungsabschnitten mit Schaltungsblöcken SYS_{A} und SYS_{B} bietet einen vollständigen Schutz gegen Single-Event-Upsets. Die Schaltungsblöcke enthalten eine Vielzahl oben beschriebener Speicherelemente und Auswahlschaltungen zur Handhabung von Single-Event-Upsets. Die Schaltungsblöcke SYS_{A} und SYS_{B} senden jeweils k Bit breite Signalvektoren ihrer jeweiligen Anzahl von k Speicherelementen über entsprechende, mit FF_{A} bzw. FF_{B} gekennzeichnete Ausgänge auf der einen Seite an eine entsprechende Anzahl Auswahlschaltungen auf der anderen Seite (Eingänge V_{B} bzw. V_{A}).

Eine explizite Synchronisation der beiden Schaltungsblöcke SYS_{A} und SYS_{B} nach einem Single-Event-Upset ist nicht erforderlich, da sie automatisch mit der nächsten aktiven Taktflanke erfolgt. Vorteilhaft bei dem hier dargestellten Schaltungsdesign ist ebenfalls, dass nach einem SEU keine Verzögerung bei Eingabe- oder Ausgabeoperationen in der Kommunikation mit externen Schaltungsteilen auftritt. Auf diese Weise ist das hier vorgeschlagene Design echtzeitfähig. Bei Bedarf kann aufgrund der unabhängigen Spannungsversorgung einer der beiden Schaltungsblöcke SYS_{A} oder SYS_{B} zeitweise abgeschaltet werden, wenn keine Single-Event-Effekte zu erwarten sind. In diesem Fall kann alternativ auch vorgesehen werden, dass beide Schaltungsblöcke SYS_{A} und SYS_{B} zeitweise für unterschiedliche Zwecke verwendet werden, indem sie separate oder gemultiplexte Eingänge und Ausgänge erhalten. Für die Zeitdauer des unabhängigen Betriebs der beiden Schaltungsabschnitte SYS_{A} und SYS_{B} werden dann die jeweiligen Eingänge und Ausgänge der beiden Schaltungsabschnitte anders verschaltet.

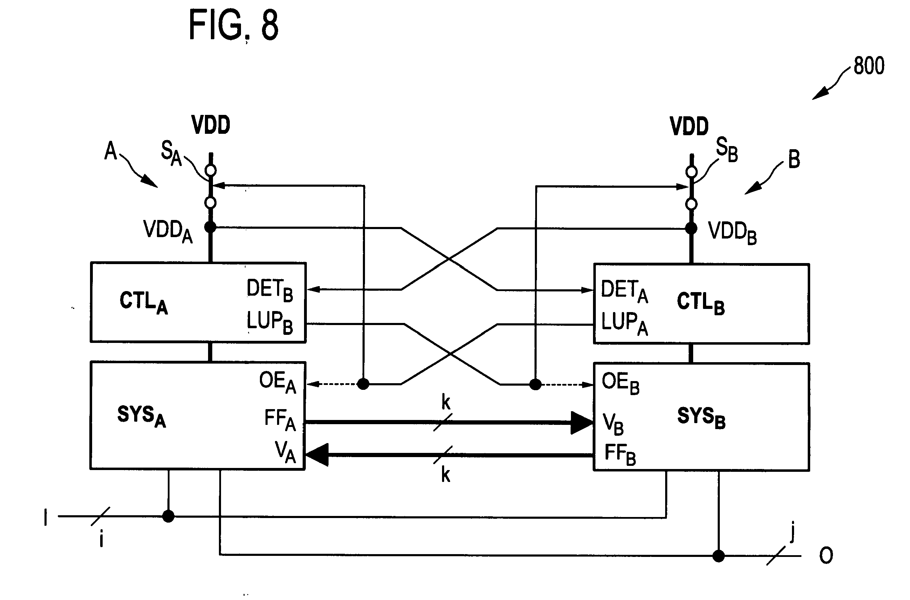

Fig. 8 zeigt eine vereinfachte Darstellung eines Ausführungsbeispiels eines elektrischen Schaltkreises mit Steuereinheiten zur zusätzlichen Handhabung von Single-Event-Latchups. Der elektrische Schaltkreis der Fig. 8 entspricht in seiner Grundstruktur dem elektrischen Schaltkreis 700 der Fig. 7. Zusätzlich ist zur Latchup-Kontrolle in jedem Schaltungsabschnitt A bzw. B eine Steuerungseinheit CTL_{A} bzw. CTL_{B} vorgesehen. Beide Steuereinheiten CTL_{A} und CTL_{B} enthalten jeweils einen Latchup-Detektor DET_{B} bzw. DET_{A}. Der Latchup-Detektor DET_{B} der Steuerungseinheit CTL_{A} überwacht den Schaltungsabschnitt B auf das Vorliegen eines Single-Event-Latchups. Umgekehrt überwacht der Latchup-Detektor DET_{A} den Schaltungsabschnitt A auf das Auftreten eines Single-Event-Latchups. Das Auftreten eines Latchups wird dem jeweils anderen Schaltkreis über Signalausgänge LUP_{B} bzw. LUP_{A} signalisiert. Mit Hilfe von on-Chip angeordneten, über Steuerausgänge LUP_{A} (im Schaltungsabschnitt B) LUP_{B} (im Schaltungsabschnitt A) der Steuerungseinheiten gesteuerten Schaltern S_{A} (im Schaltungsabschnitt A) und S_{B} (im Schaltungsabschnitt B), die als Strombegrenzer arbeiten, kann bei Vorliegen eines entsprechenden Signals ein SEL-Schutz realisiert werden. Gestrichelte Pfeile, die zu Eingängen OE_{A} bzw. OE_{B} führen, symbolisieren, dass im Fall einer Spannungsabschaltung über diese Eingänge OE_{A} bzw. OE_{B} den weiterhin aktiven Voter-Eingängen ein gültiger Logikpegel zugeführt wird.

Es ist vorteilhaft, relativ kleine Schaltkreisabschnitte durch derartige Strombegrenzer zu kontrollieren. Bei kleineren Schaltkreisabschnitten ist die Wahrscheinlichkeit geringer, dass ein SEL oder SEU in einem Schaltkreisabschnitt auftritt, während im dazu redundanten Schaltkreisabschnitt noch ein SEL beseitigt wird.

Es können in diesem Fall auch Mikro-Latchups detektiert werden, was die Zuverlässigkeit und Sicherheit der elektrischen Schaltung weiter erhöht. Ein wesentlicher Vorteil ist auch, dass die gleiche Redundanz und die gleiche automatische Synchronisierung über die Auswahlschaltungen benutzt werden wie für den SEU-Schutz benötigt. Damit ist ebenfalls Echtzeitfähigkeit gewährleistet.

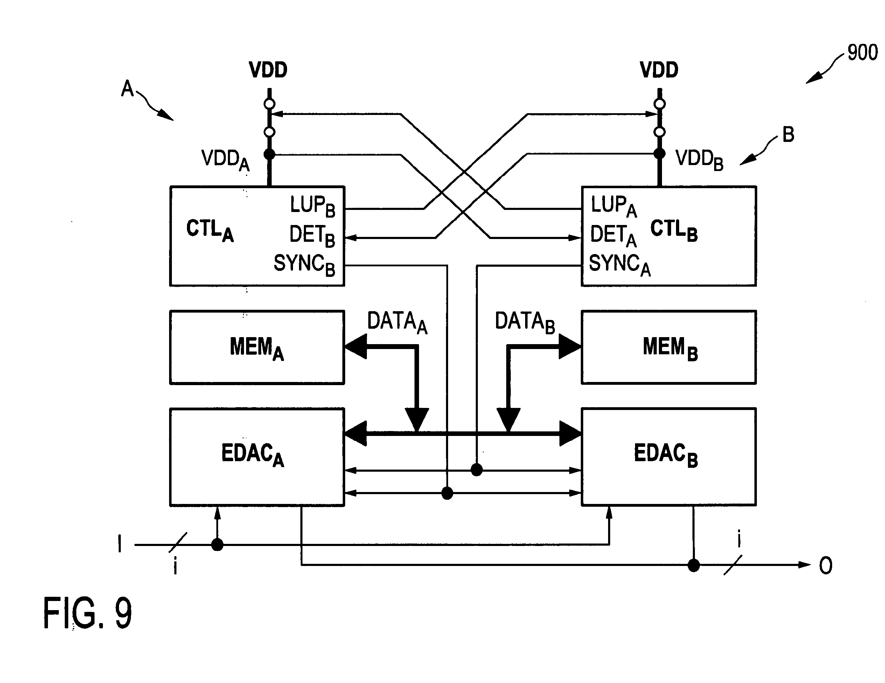

Fig. 9 zeigt eine Variante des Schaltkreises der Fig. 8 in Form einer Speicherschaltung 900 mit Schutz gegen Single-Event-Upsets und Single-Event-Latchups. Der Aufbau der Speicherschaltung 900 entspricht im wesentlichen dem Aufbau des elektrischen Schaltkreises 800 der Fig. 8. Jeder der Schaltungsabschnitte A und B enthält eine Steuerungseinheit CTL_{A} bzw. CTL_{B} zur Latchup-Kontrolle des jeweils anderen Schaltungsabschnitts. Den Steuerungseinheiten nachgeschaltet sind in den jeweiligen Schaltungsabschnitten Speicherbereiche MEM_{A} bzw. MEM_{B}. Die Speicherbereiche MEM_{A} und MEM_{B} sind jeweils mit Schaltungsblöcken zur Fehlererkennung und -korrektur (engl.: Error Detection and Correction, EDAC) EDAC_{A} und EDAC_{B} verbunden. Die Steuerungslogik CTL_{A} und die Steuerungslogik CTL_{B} überwachen in der zuvor beschriebenen Weise die Spannungsversorgung VDD_{B} bzw. VDD_{A}.

Die Synchronisationsaufforderung erfolgt über die Signale SYNC_{A} bzw. SYNC_{B}, welche an die zusätzlichen Blöcke EDAC_{A} und EDAC_{B} ausgegeben werden. Die EDAC-Blöcke detektieren und korrigieren zunächst alle Fehler, die z.B. durch SEU auftreten. Dies wird z. B. durch zusätzliche Parity-Bits bzw. Hamming-Codes ermöglicht. Zur Implementierung des Hamming-Codes kann die Wortbreite um zusätzliche Bits vergrößert werden.

Falls ein SEL aufgetreten ist, wird das anschließend, d.h. nach dem Wiedereinschalten der Betriebsspannung über die Signale SYNC_{A} bzw. SYNC_{B} mitgeteilt und beide EDAC-Blöcke EDAC_{A} und EDAC_{B} übernehmen dann die Synchronisierung. Der nicht SELbetroffene EDAC-Controller liest sämtliche Daten aus seinem Speicher und leitet sie direkt dem anderen SEL-Controller zu. Der schreibt parallel alle Daten in seinen zu synchronisierenden Speicher. Gleichzeitig werden natürlich auch eventuelle, z.B. durch SEU entstandene, Bitfehler z.B. durch die oben genannten Hamming-Codes erkannt und korrigiert. Diese Kontrolle bzw. Korrektur wird im normalen Betrieb (d.h. ohne aufgetretenen SEL) ergänzt durch den Vergleich der Daten DATA_{A}, DATA_{B} der beiden redundanten Speicher MEM_{A}, MEM_{B}. Dieser Vergleich hat Vorteile, wenn ein EDAC-Controller z. B. wegen MBU nicht mehr in der Lage ist einen Fehler zu korrigieren. In einem solchen Fall kann der richtige Wert vom jeweils anderen Speicher übernommen werden.

Eine Synchronisierung im Hintergrund während des Betriebs ist möglich, solange die Frequenz des Speicherzugriffs von extern dies nicht verhindert. Um in diesem Fall eine Echtzeitfähigkeit der Speicherschaltung 900 zu gewährleisten, kann ein zweiter Speicherport zur Synchronisierung des vom SEL betroffenen Speichers vorgesehen werden.

Zur Vermeidung von Multiple-Bit-Upsets (MBU) ist es sinnvoll, alle Speicherdaten zyklisch auszulesen und gegebenenfalls korrigierte Daten wieder in den Speicher einzuschreiben. Dieser Vorgang wird auch als "Scrubbing" bezeichnet. Auch das Scrubbing kann mit Hilfe eines zweiten Speicherports durchgeführt werden, um die Echtzeitfähigkeit der Speicherschaltung zu gewährleisten.

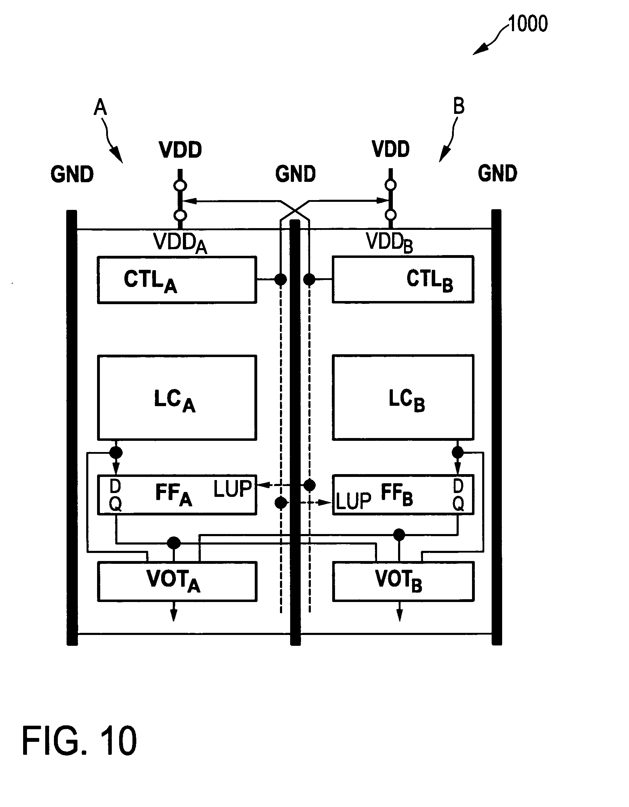

Fig. 10 zeigt eine schematische Darstellung eines anwendungsspezifischen integrierten Schaltkreises (Application Specific Integrated Circuit, ASIC) 1000 mit Schutz gegen Single-Event-Upsets und Single-Event-Latchups. Fig. 10 dient zur Veranschaulichung eines geeigneten Layouts, das den durch die redundante Schaltungsstruktur erforderlichen zusätzlichen Platzbedarf eines SEU/SEL-geschützten elektrischen Schaltkreises so gering wie möglich hält. Mit Hilfe eines geeigneten Schaltungsdesigns kann zusätzlich die erforderliche synchrone Taktsteuerung der beiden redundanten Schaltungsabschnitte gewährleistet werden.

Gemäß dieser Ausgestaltung lassen sich die erfindungsgemäßen Schalkreisabschnitte A und B im Standardzellendesign realisieren. Das jeweilige System SYS_{A}, SYS_{B}, ist wiederum über Schalter S_{A}, S_{B}, an die Versorgungsspannung gekoppelt. Im oberen Bereich, also der Spannungsversorgung VDD_{A}, VDD_{B}, zugeordnet sind die Steuerungseinheiten CTL_{A} und CTL_{B}. Die Ansteuerung der Schalter S_{A}, S_{B}, ist hier näher nicht dargestellt, erfolgt jedoch genauso wie bezüglich der vorangegangenen Figuren erläutert. Im mittleren Bereich befinden sich die logischen Zellen (Logic Cells) LC_{A} und LC_{B}, welche die Funktion bzw. die entsprechende Logik zur Umsetzung der Funktionen, die das System realisieren soll, beinhalten. Weiter sind die Flipflops FF_{A}, und FF_{B} vorgesehen, welche grundsätzlich genauso agieren wie oben beschrieben. Die Auswahlschaltungen sind hier als einzelne Blöcke VOT_{A} und VOT_{B} dargestellt. Diese nehmen die Auswahl der entsprechenden Ausgangssignale vor und entscheiden, welcher der Schaltkreisabschnitte A, B einen Fehler verursacht hat und daher über die nicht von einem SEL oder ähnlichen Ereignis betroffenen Systeme synchronisiert werden muss.

Bei der in Fig. 10 dargestellten Anordnung der einzelnen Komponenten bzw. der erforderlichen Blöcke kann der Verdrahtungsaufwand in sehr vorteilhafter Weise minimiert werden. Die Schaltungsabschnitte A und B sind in benachbarten Blöcken angeordnet, die durch Masse-Leitungen GND voneinander getrennt sind. Die Verbindung von Auswahlschaltungen in einem elektrischen Schaltkreis wie dem der Fig. 10 erfordert eine Vielzahl von Verbindungsleitungen zwischen den unabhängig mit elektrischer Leistung versorgten Schaltungsabschnitten A und B. Das Routen der Verbindungsleitungen ist vereinfacht, wenn die Speicherelement und Auswahlschaltungen in neben einander liegenden Spalten auf gleicher Höhe angeordnet werden. Dabei sind jeweils gleichartige Funktionsblöcke der Schaltungsabschnitte A und B in direkter Nachbarschaft in den benachbarten Blöcken, d. h. auf jeweils gleicher Höhe angeordnet.

## Patentansprüche

1. Elektrischer Schaltkreis (200; 300') mit
- zwei zueinander parallelgeschalteten und redundanten sequentiellen Logikschaltungen (208, 210; 308, 310), denen nominell-identische logische Eingangssignale zugeführt sind, und die ausgebildet sind, die jeweils eingehenden logischen Eingangssignale synchron auf identische Weise zu verarbeiten und entsprechende erste und zweite logische Ausgangssignale auszugeben,
- einer den sequentiellen Logikschaltungen (208, 210; 308, 310) nachgeschalteten ersten Auswahlschaltung (212; 312), die ausgebildet ist, an ihrem Ausgang ein drittes logisches Ausgangsignal auszugeben, das einer Mehrheit von drei Eingangssignalen entspricht, welche parallel an drei Eingängen der ersten Auswahlschaltung (212; 312) anliegen, wobei einem ersten der drei Eingänge das erste logische Ausgangssignal einer ersten (208; 308) der zwei redundanten sequentiellen Logikschaltungen (208, 210; 308, 310) und einem zweiten der drei Eingänge das zweite logische Ausgangssignal einer zweiten (210; 310) der zwei redundanten sequentiellen Logikschaltungen (208, 210; 308, 310) zugeführt ist, und wobei das dritte logische Ausgangssignal der ersten Auswahlschaltung (212; 312) auf einen dritten der drei Eingänge der ersten Auswahlschaltung (212; 312) rückgeführt ist,
- einer ersten kombinatorischen Logik (202; 302) und einer zur ersten redundanten und parallelgeschalteten zweiten kombinatorischen Logik (204; 304), die der ersten und zweiten sequentiellen Logikschaltung (208, 210; 308, 310) vorgeschaltet sind, wobei die erste kombinatorischen Logik (202; 302) nur mit der ersten (208; 308) der zwei sequentiellen Logikschaltungen und die zweite kombinatorische Logik (204; 304) nur mit der zweiten (210; 310) der zwei sequentiellen Logikschaltungen verbunden ist, und mit
- einer der ersten Auswahlschaltung (212; 312) parallelgeschalteten und zu ihr redundanten zweiten Auswahlschaltung (214; 314), die ausgebildet ist, an ihrem Ausgang ein viertes logisches Ausgangssignal auszugeben, das einer Mehrheit von drei Eingangssignalen entspricht, welche parallel an drei Eingängen der zweiten Auswahlschaltung (214; 314) anliegen, wobei einem ersten der drei Eingänge das erste logische Ausgangssignal der ersten sequentiellen Logikschaltung (208; 308) und einem zweiten der drei Eingänge das zweite logische Ausgangssignal der zweiten sequentiellen Logikschaltung (210; 310) zugeführt ist, und wobei das vierte logische Ausgangssignal der zweiten Auswahlschaltung (214; 314) auf einen dritten der drei Eingänge der zweiten Auswahlschaltung (214; 314) rückgeführt ist, wobei
- jede sequentielle Logikschaltung (208, 210; 308, 310) ein D-Flipflop umfasst, dem jeweils eines der nominell identischen logischen Eingangssignale zugeführt ist und das am Ausgang der sequentiellen Logikschaltung angeordnet und ausgebildet ist, das erste bzw. zweite logische Ausgangssignal auszugeben, wobei Taktsignaleingängen der D-Flipflops zueinander synchrone Taktsignale zugeführt sind und wobei
- der ersten kombinatorischen Logik (202; 302) und dem Takteingang des ersten D-Flipflops (208; 308) ein erstes Taktsignal zugeführt ist und der zweiten kombinatorischen Logik (204; 304) und dem Takteingang des zweiten D-Flipflops (210; 310) ein vom ersten unabhängiges zweites Taktsignal zugeführt ist, das mit dem ersten Taktsignal synchron ist und
- die erste und zweite Auswahlschaltung (312, 314) jeweils eine Zusatzschaltung (318, 316) aufweisen, an welcher eingangsseitig ein Ausgangssignal jeweils einer der zwei zueinander redundanten kombinatorischen Logikschaltungen (302, 304) anliegt und die ausgebildet ist, in einem bestimmten Zeitbereich vor und nach einer aktiven Taktflanke des jeweiligen Taktsignals dem dritten Eingang der betreffenden Auswahlschaltung (312; 314) anstelle des dritten Ausgangssignals der betreffenden Auswahlschaltung (312; 314) das an der jeweiligen Zusatzschaltung (318; 316) eingangsseitig anliegende Ausgangssignal der betreffenden kombinatorischen Logikschaltung (302; 304) zuzuführen.

2. Elektrischer Schaltkreis (300') nach Anspruch 1, bei dem
- die Zusatzschaltung (318) einen Multiplexer (318) zwischen dem Ausgang der ersten Auswahlschaltung (312) und den mit ihm verbundenen dritten Eingang der ersten Auswahlschaltung (312) aufweist, dem an parallelen ersten und zweiten Multiplexer-Signaleingängen das Ausgangssignal der ersten Auswahlschaltung (312) und das logische Eingangssignal der zugeordneten sequentiellen Logikschaltung (308) zugeführt sind,
- wobei dem Multiplexer (318) ein periodisches Hilfstaktsignal zugeführt ist, das zum Taktsignal synchron ist und Hilfstakt-Signalimpulse aufweist, die in einem bestimmten Zeitbereich vor und nach einer aktiven Taktflanke des jeweiligen Taktsignals ein konstantes logischen Hilfstakt-Signalniveau haben, und wobei
- der Multiplexer (318) ausgebildet ist, bei Vorliegen des Hilfstakt-Signalimpulses dem dritten Eingang der Auswahlschaltung (312) anstelle des Ausgangs der Auswahlschaltung (312) das eingangsseitig anliegende logische Signal zuzuführen.

3. Elektrischer Schaltkreis (300') nach Anspruch 2, mit einer Hilfstaktschaltung (322; 320), die eingangsseitig das Taktsignal empfängt und die ausgebildet ist, das periodische Hilfstaktsignal auszugeben.

4. Elektrischer Schaltkreis (300') nach Anspruch 3, bei dem die Auswahlschaltung (312; 314), die Zusatzschaltung (318; 316) die zugeordnete Hilfstaktschaltung (322; 320) eine Makrozelle bilden.

5. Elektrischer Schaltkreis (800; 900; 1000) nach einem der vorstehenden Ansprüche, bei dem
- die erste kombinatorische Logik (202; 302) mit der ersten sequentiellen Logikschaltung (208; 308) und der ersten Auswahlschaltung (212; 312) einen ersten Schaltkreisabschnitt bildet,
- die zweite kombinatorische Logik (204; 304) mit der zweiten sequentiellen Logikschaltung (210; 310) und der zweiten Auswahlschaltung (212; 312) einen zweiten Schaltkreisabschnitt bildet, und bei dem
- der erste Schaltkreisabschnitt einen ersten Spannungsversorgungsanschluss und der zweite Schaltkreisabschnitt einen zweiten Spannungsversorgungsanschluss aufweist, wobei die Spannungsversorgungsanschlüsse mit unabhängigen Spannungsversorgungsquellen verbindbar sind.

6. Elektrischer Schaltkreis (800; 900; 1000) nach Anspruch 5, bei dem
- der erste Schaltkreisabschnitt eine erste Steuereinheit umfasst, welche mit dem zweiten Schaltkreisabschnitt verbunden und ausbildet ist, in Reaktion auf ein Auftreten eines Single-Event-Latchups im zweiten Schaltkreisabschnitt die Stromaufnahme des zweiten Schaltkreisabschnittes zu begrenzen, und
- der zweite Schaltkreisabschnitt eine zweite Steuereinheit umfasst, welche mit dem ersten Schaltkreisabschnitt verbunden und ausgebildet ist, in Reaktion auf ein Auftreten eines Single-Event-Latchups im ersten Schaltkreisabschnitt die Stromaufnahme des ersten Schaltkreisabschnittes zu begrenzen.

7. Elektrischer Schaltkreis (800; 900; 1000) nach Anspruch 6, bei dem die Steuereinheit einen Latchup-Detektor umfasst, der ausgebildet ist, einen auf einem Single-Event-Latchup beruhenden Stromausschlag zu detektieren.

## Claims

1. Electric circuit (200; 300') having
- two sequential logic circuits (206, 210; 308, 310) connected in parallel and redundant with one another, which are supplied with nominally identical logic input signals, and which are configured to process the incoming logic input signals synchronously in identical manner and to emit corresponding first and second logic output signals,
- a first selection circuit (212; 312) connected downstream of the sequential logic circuits (206, 210; 308, 310), which is configured to emit, at its output, a third logic output signal which corresponds to a majority of three input signals which are present in parallel at three inputs of the first selection circuit (212; 312), a first of the three inputs being supplied with the first logic output signal from a first (208; 308) of the two redundant sequential logic circuits (208, 210; 308, 310) and a second of the three inputs being supplied with the second logic output signal from a second (210; 310) of the two redundant sequential logic circuits (208, 210; 308, 310), and the third logic output signal from the first selection circuit (212; 312) being fed back to a third of the three inputs of the first selection circuit (212; 312),
- a first combinational logic (202; 302) and a second combinational logic (204; 304) that is redundant with and connected in parallel to the first, which are connected upstream of the first and second sequential logic circuits (208, 210; 308, 310), the first combinational logic (202; 302) being connected only to the first (208; 308) of the two sequential logic circuits and the second combinational logic (204; 304) being connected only to the second (210; 310) of the two sequential logic circuits, and having
- a second selection circuit (214; 314) connected in parallel to the first selection circuit (212; 312) and redundant therewith, which is configured to emit, at its output, a fourth logic output signal which corresponds to a majority of three input signals which are present in parallel at three inputs of the second selection circuit (214; 314), a first of the three inputs being supplied with the first logic output signal from the first sequential logic circuit (208; 308) and a second of the three inputs being supplied with the second logic output signal from the second sequential logic circuit (210; 310), and the fourth logic output signal from the second selection circuit (214; 314) being fed back to a third of the three inputs of the second selection circuit (214; 314),
- each sequential logic circuit (208, 210; 308, 310) comprising a D flip-flop which is supplied in each case with one of the nominally identical logic input signals and which is arranged at the output of the sequential logic circuit and is configured to emit the first or second logic output signal, respectively, clock signal inputs of the D flip-flops being supplied with clock signals that are synchronous with one another, and
- the first combinational logic (202; 302) and the clock input of the first D flip-flop (208; 308) being supplied with a first clock signal and the second combinational logic (204; 304) and the clock input of the second D flip-flop (210; 310) being supplied with a second clock signal independent of the first, which is synchronous with the first clock signal, and
- the first and second selection circuit (312, 314) each comprise an additional circuit (318, 316) to which is applied, on the input side, an output signal from, in each case, one of the two combinational logic circuits (302, 304) that are redundant with one another, and which is embodied to supply the output signal from the relevant combinational logic circuit (302; 304) that is present on the input side of the respective additional circuit (318; 316) to the third input of the relevant selection circuit (312; 314) instead of the third output signal from the relevant selection circuit (312; 314), within a certain period of time before and after an active clock flank of the respective clock signal.

2. Electric circuit (300') according to claim 1, wherein
- the additional circuit (318) comprises a multiplexer (318) between the output of the first selection circuit (312) and the third input of the first selection circuit (312) connected thereto, said multiplexer being supplied with the output signal of the first selection circuit (312) and the logic input signal of the associated sequential logic circuit (308), at parallel first and second multiplexer signal inputs,
- the multiplexer (318) being supplied with a periodic auxiliary clock signal which is synchronous with the clock signal and comprises auxiliary clock signal pulses that have a constant logic auxiliary clock signal level within a certain period of time before and after an active clock flank of the respective clock signal, and
- the multiplexer (318) being configured to supply the logic signal present at the input end to the third input of the selection circuit (312) instead of the output of the selection circuit (312) when the auxiliary clock signal pulse is present.

3. Electric circuit (300') according to claim 2, having an auxiliary clock circuit (322; 320) which receives the clock signal on the input side and is configured to emit the periodic auxiliary clock signal.

4. Electric circuit (300') according to claim 3, wherein the selection circuit (312; 314), the additional circuit (318; 316) the associated auxiliary clock circuit (322; 320) form a macrocell.

5. Electric circuit (800; 900; 1000) according to one of the preceding claims, wherein
- the first combinational logic (202; 302) forms a first circuit section with the first sequential logic circuit (208; 308) and the first selection circuit (212; 312),
- the second combinational logic (204; 304) forms a second circuit section with the second sequential logic circuit (210; 310) and the second selection circuit (212; 312), and wherein
- the first circuit section comprises a first voltage supply connection and the second circuit section comprises a second voltage supply connection, the voltage supply connections being connectable to independent voltage supply sources.

6. Electric circuit (800; 900; 1000) according to claim 5, wherein
- the first circuit section comprises a first control unit which is connected to the second circuit section and is configured to limit the current drain of the second circuit section in response to the occurrence of a single-event latch-up in the second circuit section, and
- the second circuit section comprises a second control unit which is connected to the first circuit section and is configured to limit the current drain of the first circuit section in response to the occurrence of a single-event latch-up in the first circuit section.

7. Electric circuit (800; 900; 1000) according to claim 6, wherein the control unit comprises a latch-up detector which is configured to detect a current change based on a single-event latch-up.

## Revendications

1. Circuit électrique (200 ; 300') avec
- deux circuits logiques (208, 210 ; 308, 310) séquentiels branchés en parallèle et redondants dans lesquels sont introduits des signaux d'entrée logiques nominalement identiques et qui sont conçus pour traiter les signaux d'entrée entrants de manière synchrone et identique et pour générer des premiers et deuxièmes signaux de sortie logiques correspondants,
- un premier circuit de sélection (212 ; 312) branché en aval des circuits logiques séquentiels (208, 210 ; 308, 310), qui est conçu pour générer, à leur sortie, un troisième signal de sortie logique qui correspond à une majorité des trois signaux de sortie, qui sont appliqués à trois entrées du premier circuit de sélection (212 ; 312), le premier signal de sortie logique d'un premier (208; 308) des deux circuits logiques séquentiels (208, 210 ; 308, 310) étant introduit dans une première des trois entrées et le deuxième signal de sortie d'un deuxième (210 ; 310) des deux circuits logiques séquentiels (208, 210 ; 308, 310) étant introduit dans une deuxième des trois entrées, et le troisième signal de sortie logique du premier circuit de sélection (212 ; 312) étant retourné sur une troisième des trois entrées du premier circuit de sélection,
- un première logique combinatoire (202 ; 302) et une deuxième logique combinatoire (204 ; 304) redondante et branchée en parallèle avec la première, qui sont branchées en amont du premier et du deuxième circuit logique séquentiel (208, 210 ; 308, 310) et la première logique combinatoire (202 ; 302) étant relié uniquement avec le premier (208 ; 308) des deux circuits logiques séquentiels et la deuxième logique combinatoire (204 ; 304) étant reliée uniquement avec le deuxième (210 ; 310) des deux circuits logiques séquentiels, et avec
- un deuxième circuit de sélection (214 ; 314) branché en parallèle et redondant par rapport au premier circuit de sélection (212 ; 312), qui est conçu pour générer, à sa sortie, un quatrième signal de sortie logique, qui correspond à une majorité de trois signaux d'entrée appliqués de manière parallèle au niveau de trois entrées du deuxième circuit de sélection (214 ; 314), le premier signal de sortie logique du premier circuit logique séquentiel (208 ; 308) étant introduit dans une première des trois entrées et le deuxième signal de sortie logique du deuxième circuit logique séquentiel (210 ; 310) étant introduit dans la deuxième des trois entrées, et le quatrième signal de sortie logique du deuxième circuit de sélection (214 ; 314) étant retourné vers une troisième des trois entrées du deuxième circuit de sélection (214 ; 314),
- chaque circuit logique séquentiel (208, 210 ; 308, 310) comprenant une bascule D dans laquelle est introduit un des signaux d'entrée logiques nominalement identiques et qui est disposée à la sortie du circuit logique séquentiel et conçue pour générer le premier ou le deuxième signal de sortie logique, des signaux d'horloge synchrone entre eux étant introduits dans les entrées de signaux d'horloge de la bascule D, et
- un premier signal d'horloge étant introduit dans la première logique combinatoire (202 ; 302) et l'entrée d'horloge de la première bascule D (208 ; 308) et un deuxième signal d'horloge, indépendant du premier et synchrone avec le premier signal d'horloge, étant introduit dans la deuxième logique combinatoire (204 ; 304) et dans l'entrée d'horloge de la deuxième bascule D (210 ; 310), et
- le premier et le deuxième circuit de sélection (312, 314) comprenant chacun un circuit supplémentaire (318, 316) auquel est appliqué, du côté de l'entrée, un signal de sortie d'un des deux circuits logiques combinatoires (302, 304) redondants entre eux, et qui est conçu pour introduire, dans un laps de temps déterminé avant et après un flanc actif du signal d'horloge correspondant, dans la troisième entrée du circuit de sélection (312 ; 314) concerné, au lieu du troisième signal de sortie du circuit de sélection (312 ; 314) concerné, le signal de sortie du circuit logique combinatoire (302 ; 304) concerné, appliqué à l'entrée du circuit supplémentaire (318 ; 316) correspondant.

2. Circuit électrique (300') selon la revendication 1, dans lequel
- le circuit supplémentaire (318) comprend un multiplexeur (318) entre la sortie du premier circuit de sélection (312) et la troisième entrée, reliée avec celui-ci, du premier circuit de sélection (312), dans lequel sont introduits, au niveau des première et deuxième entrées de signaux de multiplexeur parallèles, le signal de sortie du premier circuit de sélection (312) et le signal d'entrée logique du circuit logique séquentiel (308),
- un signal d'horloge auxiliaire périodique, synchrone par rapport au signal d'horloge et comprenant des impulsions de signaux d'horloge auxiliaires qui présentent, dans un laps de temps déterminé avant et après un flanc actif du signal d'horloge correspondant, un niveau de signal d'horloge auxiliaire logique constant, étant introduit dans le multiplexeur (318), et
- le multiplexeur (318) étant conçu pour introduire, en présence de l'impulsion de signal d'horloge auxiliaire, dans la troisième entrée du circuit de sélection (312), au lieu de la sortie du circuit de sélection (312), le signal logique appliqué à l'entrée.

3. Circuit électrique (300') selon la revendication 2, avec un circuit d'horloge auxiliaire (322 ; 320) qui reçoit à l'entrée le signal d'horloge et qui est conçu pour générer le signal d'horloge auxiliaire périodique.

4. Circuit électrique (300') selon la revendication 3, dans lequel le circuit de sélection (312 ; 314), le circuit supplémentaire (318 ; 316) et le circuit d'horloge auxiliaire (322 ; 320) forment une macro-cellule.

5. Circuit électrique (800 ; 900 ; 1000) selon l'une des revendications précédentes, dans lequel
- la première logique combinatoire (202 ; 302) forme, avec le premier circuit logique séquentiel (208 ; 308) et le premier circuit de sélection (212 ; 312), une première partie de circuit,
- la deuxième logique combinatoire (204 ; 304) forme, avec le deuxième circuit logique séquentiel (210 ; 310) et le deuxième circuit de sélection (212 ; 312), une deuxième partie de circuit et dans lequel
- la première partie de circuit comprend un premier connecteur d'alimentation en tension et la deuxième partie de circuit comprend un deuxième connecteur d'alimentation en tension, les connecteurs d'alimentation en tension pouvant reliés à des sources d'alimentation en tension indépendantes.

6. Circuit électrique (800 ; 900 ; 1000) selon la revendication 5, dans lequel
- la première partie de circuit comprend une première unité de commande reliée à la deuxième partie de circuit et conçue pour limiter, en réaction à un évènement singulier (Single Event Latchup), dans une deuxième partie de circuit, la consommation de courant de la deuxième partie de circuit, et
- la deuxième partie de circuit comprend une deuxième unité de commande reliée à la première partie de circuit et conçue pour limiter, en réaction à un évènement singulier (Single Event Latchup), dans une première partie de circuit, la consommation de courant de la première partie de circuit.

7. Circuit électrique (800 ; 900 ; 1000) selon la revendication 6, dans lequel l'unité de commande comprend un détecteur de Latchup (verrouillage) conçu pour détecter un appel de courant résultant d'un Single Event Latchup.
